# EUROPÄISCHE PATENTSCHRIFT

(11) **EP 2 531 868 B1**
(45) Veröffentlichungstag und Bekanntmachung des Hinweises auf die Patenterteilung: **25.06.2014**
(21) Anmeldenummer: 11700323.6
(22) Anmeldetag: 03.01.2011
(51) Int. Cl.: G01R 31/36

(54) **ADAPTIVES VERFAHREN ZUR BESTIMMUNG DER MAXIMAL ABGEBAREN ODER AUFNEHMBAREN LEISTUNG EINER BATTERIE**
ADAPTIVE METHOD FOR DETERMINING THE POWER THAT CAN BE MAXIMALLY OUTPUTTED OR ABSORBED BY A BATTERY
PROCÉDÉ ADAPTATIF PERMETTANT DE DÉTERMINER LA PUISSANCE MAXIMALE POUVANT ÊTRE FOURNIE OU STOCKÉE PAR UNE BATTERIE

(30) Priorität: 03.02.2010 DE 102010001529
(43) Veröffentlichungstag der Anmeldung: 12.12.2012
(73) Patentinhaber: Samsung SDI Co., Ltd., Gyeonggi-do (KR); Robert Bosch GmbH, 70442 Stuttgart (DE)
(72) Erfinder: BOEHM, Andre, 70806 Kornwestheim (DE); WEBER, Jochen, 71706 Markgroeningen (DE)
(74) Vertreter: Bee, Joachim
(86) Internationale Anmeldenummer: PCT/EP2011/050024
(87) Internationale Veröffentlichungsnummer: WO 2011/095368

(56) Entgegenhaltungen:
- EP-A2- 1 598 913
- WO-A1-2006/126827
- DE-A1-102007 005 241
- US-A1- 2004 222 797

## Beschreibung

### Stand der Technik

Die Erfindung betrifft ein Verfahren zur Bestimmung der von einer Batterie zur Verfügung stellbaren oder aufnehmbaren Leistung, ein Batteriesystem, welches ausgebildet ist, das Verfahren auszuführen, sowie ein Kraftfahrzeug mit einem solchen Batteriesystem.

In Hybrid- und Elektrofahrzeugen werden Batterien in Lithium-lonen- oder NiMH-Technologie eingesetzt, die eine große Anzahl in Serie geschaltete elektrochemische Batteriezellen aufweisen. Ein Batteriemanagementsystem wird zur Überwachung der Batterie eingesetzt und soll neben einer Sicherheitsüberwachung eine möglichst hohe Lebensdauer gewähren. Dazu wird die Spannung jeder einzelnen Batteriezelle zusammen mit dem Batteriestrom und der Batterietemperatur gemessen und eine Zustandsschätzung (beispielsweise des Ladezustandes oder des Alterungszustandes der Batterie) vorgenommen. Um die Lebensdauer zu maximieren, ist es hilfreich, jederzeit die aktuell gegebene maximale Leistungsfähigkeit der Batterie, also die maximal abgeb- oder aufnehmbare elektrische Leistung, zu kennen. Wird diese Leistungsfähigkeit überschritten, kann die Alterung der Batterie stark beschleunigt werden.

Der Betriebsbereich eines elektrochemischen Energiespeichers kann als mehrdimensionaler Raum charakterisiert werden, der gebildet wird durch Zustandsgrößen wie z.B. Temperatur, Ladezustand oder Stromstärke. Im Stand der Technik sind zahlreiche Verfahren bekannt, die das Verhalten einer Batterie unter den jeweils gegebenen Belastungen und Zustandsgrößen nachbilden und so für das Batteriemanagement modellieren sollen. Ein Verfahren ist die Speicherung von Leistungs- oder Energiewerten des elektrochemischen Energiespeichers in einer mehrdimensionalen Tabelle, die dem Betriebsbereich entspricht. Die Erstellung einer solchen Tabelle erfordert eine aufwendige detaillierte Vermessung der Eigenschaften des Energiespeichers im Labor und berücksichtigt in der Regel weder Variationen der Eigenschaften der Batterien aufgrund von Produktionsstreuungen oder durch Alterung. Ein zweiter Ansatz basiert auf einer Nachbildung des elektrochemischen Energiespeichers durch ein geeignetes Simulationsmodell, dessen Parameter an das reale Verhalten angepasst werden. Mit Hilfe dieses Modells und der bekannten Parameter kann dann eine Zustandsvorhersage getroffen werden. Nachteil dieses Verfahrens ist, dass das komplexe Verhalten elektrochemischer Energiespeicher teilweise nichtlinear ist und daher nur unzureichend durch einfache Modelle beschrieben werden kann. Komplexe Modelle hingegen besitzen eine hohe Zahl freier Parameter, deren präzise und voneinander unabhängige Ermittlung mit großen Schwierigkeiten verbunden ist.

Aus der DE 10 2007 005 241 ist ein Verfahren und eine Vorrichtung zur Vorhersage einer Startfähigkeit eines mittels einer elektrischen Maschine startbaren Verbrennungsmotors bekannt, bei dem mindestens ein Kennwert ermittelt, aus mindestens einem der Kennwerte und/oder einem ersten gespeicherten Kennfelds ein maximales durch die elektrische Maschine über eine vorgegebene Zeitspanne ausübbares Drehmoment und aus mindestens einem der Kennwerte und/oder einem zweiten gespeicherten Kennfelds ein zu erwartendes minimales Startschleppmoment des Verbrennungsmotors bestimmt und durch Vergleich des ausübbaren Drehmoments mit dem Startschleppmoment ein Start des Verbrennungsmotors als möglich oder nicht möglich klassifiziert und/oder die Startdrehzahl bestimmt wird.

### Offenbarung der Erfindung

Ein erster Aspekt der Erfindung führt daher ein einfaches und robustes Verfahren zur Bestimmung der von einer Batterie zur Verfügung stellbaren oder aufnehmbaren Leistung ein. Das Verfahren kann beispielsweise zusätzlich zu anderen aus dem Stand der Technik bekannten Verfahren als Rückfalllösung oder zur Plausibilitätsprüfung von Ergebnissen eines solchen Verfahrens eingesetzt werden. Das Verfahren umfasst folgende Schritte:
-- Bestimmen einer Zustandsgröße der Batterie, wobei die Zustandsgröße eine Batterietemperatur und/oder ein Ladezustand ist;
-- Bestimmen einer von der Batterie während eines vorbestimmten Belastungszeitraumes zur Verfügung stellbaren oder aufnehmbaren Leistung anhand einer Tabelle von Leistungswerten und der Zustandsgröße der Batterie, wobei die Zustandsgröße der Batterie als Zugriffsparameter für die Tabelle dient;
-- Messen einer Belastung der Batterie anhand eines Betriebsparameters der Batterie, wobei der Betriebsparameter ein Batteriestrom und/oder eine Batteriespannung ist;
-- Messen eines Belastungszeitraumes, in dem die Belastung der Batterie gegeben ist;
-- Vergleichen des gemessenen Belastungszeitraumes mit einem Vergleichsbereich, der den vorbestimmten Belastungszeitraum enthält; und
-- Ausführen einer Korrekturroutine, wenn der Belastungszeitraum in dem Vergleichsbereich liegt.

Die Korrekturroutine umfasst wenigstens ein Vergleichen des Leistungswertes der Tabelle und der gemessenen Belastung, ein Bestimmen eines Korrekturwertes für den Leistungswert der Tabelle anhand eines Ergebnisses des Vergleichs des Leistungswertes der Tabelle und der gemessenen Belastung und eine Korrektur des Leistungswertes der Tabelle anhand des Korrekturwertes.

Das Verfahren der Erfindung kann das sich mit der Alterung der Batterie verändernde Verhalten einer Batterie in einer Tabelle in einfacher Weise abbilden. Dabei ist es von verhältnismäßig geringer Relevanz, ob die anfangs in der Tabelle gespeicherten Leistungswerte eine gute Abbildung der Realität darstellen, da sie mit den tatsächlich beobachteten Werten abgeglichen und abhängig von der Größe der Diskrepanz nachgeführt werden. Die Beobachtung des Verhaltens der Batterie wird anhand von vorbestimmten Belastungsfällen, z.B. der Entnahme oder Zuführung von Leistungspulsen über eine Sekunde oder zehn Sekunden hinweg, durchgeführt. Die Tabelle weist dabei bevorzugt Leistungen auf, die der Batterie über einen entsprechenden Zeitraum maximal entnommen oder zugeführt werden können, ohne dass die Batteriezellen der Batterie die minimal bzw. maximal zulässigen Spannungswerte während des Entnahme- bzw. des Aufladezeitraumes unter- bzw. überschreiten. Wird nun für einen bestimmten Zeitraum der Batterie eine bestimmte Leistung entnommen oder zugeführt, wird die Ähnlichkeit des Belastungsfalles mit dem oder den vorbestimmten Belastungsfällen bestimmt (insbesondere die Dauer und die Stärke der Belastung). Dann wird die Ähnlichkeit des vorhergesagten Verhaltens der Batterie (z.B. die Tiefe des durch eine Entnahme verursachten Einbruchs der Batteriespannung) mit dem tatsächlich gemessenen verglichen. Aus beiden Vergleichen wird ein Korrekturwert abgeleitet, der auf den jeweils zur Vorhersage des Batterieverhaltens herangezogenen Tabelleneintrag angewendet wird.

Die in der Tabelle gespeicherten Leistungswerte können so mit geringem Rechenaufwand an das tatsächliche Verhalten der Batterie angepasst werden. Das erfindungsgemäße Verfahren kommt ohne aufwendige und ggf. fehlerhafte bzw. unvollständige Modelle aus. Da das Verfahren ständig die erfassten Leistungswerte mit der Realität abgleicht, erlernt es das Verhalten der alternden Batterie automatisch und ist daher sehr robust gegen Fehler aufgrund von unbekannten oder nicht berücksichtigten Eigenschaften der Batterie.

Bei einer bevorzugten Variante des Verfahrens umfasst der Betriebsparameter der Batterie die Batteriespannung. Der bestimmte Korrekturwert ist dabei abhängig von einer Differenz der Batteriespannung am Ende des Belastungszeitraumes zu einer minimalen bzw. maximalen zulässigen Batteriespannung, insbesondere 2,8V bzw. 4,2V. Hierbei wird der Korrekturwert in Abhängigkeit von der Differenz der Batteriespannung (bzw. Zellspannung) mit der minimal bzw. maximal für die Batteriezelle zulässigen Spannung bestimmt. Je geringer die Differenz wird, desto genauer stimmen die Leistungswerte der Tabelle, die eine maximale zu entnehmende bzw. zuzuführende Leistung angeben, mit der Realität überein, weshalb auch der Korrekturwert umso geringer ausfallen muss. Diese adaptive Bestimmung des Korrekturwertes hat den Vorteil, dass sich die Leistungswerte der Tabelle schnell und stetig an einen die Realität korrekt beschreibenden Wert annähern. 2,8 und 4,2V sind die für eine Lithium-Ionen-Zelle minimal bzw. maximal zulässigen Zellspannungen. Bei Verwendung anderer Batterietechnologien können entsprechend andere Spannungen angesetzt werden.

Der bestimmte Betriebsparameter der Batterie kann auch den Batteriestrom umfassen. Der bestimmte Korrekturwert ist dann bevorzugt abhängig von einer Differenz des Batteriestromes über den Belastungszeitraum zu einem maximal zulässigen Batteriestrom in Auflade- bzw. Entladerichtung. Äquivalent zum vorbeschriebenen Fall kann ein Belastungsfall also auch über den Batteriestrom definiert werden, so dass der tatsächlich geflossene Batteriestrom auch für die Bestimmung des Korrekturwertes für den Vergleich herangezogen wird.

Der bestimmte Korrekturwert kann auch abhängig von einer Differenz des Leistungswertes der Tabelle und der gemessenen Belastung der Batterie sein. In diesem Fall wird die von der Batterie abgegebene elektrische Leistung, beispielsweise durch gleichzeitige Messung des Batteriestroms und der Batteriespannung, gemessen. Der Korrekturwert hängt dann von der Differenz des durch die Tabelle vorhergesagten Wertes und des tatsächlichen Leistungswertes ab. Das bedeutet, dass die Korrektur immer größer ausfällt, je weiter die Vorhersage von der Realität war.

Die Korrekturroutine des Verfahrens kann einen zusätzlichen Schritt des Korrigierens von weiteren Leistungswerten der Tabelle, welche zu dem Leistungswert der Tabelle in der Tabelle benachbart sind, anhand des Korrekturwertes umfassen. Diese Verfahrensvariante hat den Vorteil, dass nicht jeder einem Tabelleneintrag zugeordneter Belastungsfall auftreten muss, um aktualisierte, mit der Realität abgeglichene Leistungswerte zu erhalten. Dabei ist es auch vorstellbar, alle für eine bestimmte Zustandsgröße der Batterie oder Kombination von Zustandsgrößen gegebenen Werte gleichzeitig durch Anwendung des Korrekturwertes zu korrigieren, was den Vorteil hat, dass schnell eine große Anzahl von Leistungswerten der Tabelle durch Messungen realer Belastungsfälle aktualisiert werden. Wenn hingegen nur bestimmte, benachbarte Leistungswerte der Tabelle korrigiert werden, ist jedoch gewährleistet, dass mindestens ähnliche Randbedingungen für diese gelten wie für den tatsächlich eingetretenen Fall, was eine genauere Nachführung der Tabellenwerte näher an den tatsächlichen Eigenschaften der Batterie mit sich bringt.

Dabei kann der Korrekturwert für jeden weiteren Leistungswert gewichtet werden, wobei ein Abstand des jeweiligen weiteren Leistungswertes zu dem Leistungswert der Tabelle berücksichtigt wird. Je weiter ein zu korrigierender Leistungswert der Tabelle von dem dem tatsächlichen Belastungsfall am nächsten kommenden Tabelleneintrag entfernt ist, desto geringer ist die Aussagekraft des tatsächlichen Belastungsfalls für diesen Leistungswert. Dementsprechend wird der Korrekturwert desto niedriger gewichtet, je weiter der zu korrigierende Leistungswert von dem am nächsten kommenden Tabelleneintrag entfernt ist.

Ein zweiter Erfindungsaspekt betrifft ein Batteriesystem mit einer Batterie und einer mit der Batterie verbundenen Batteriemanagementeinheit, welche über wenigstens eine Strommesseinheit, eine Spannungsmesseinheit, einen Temperatursensor und einen Kontroller verfügt. Die Strommesseinheit ist ausgebildet, einen Batteriestrom der Batterie zu messen. Die Spannungsmesseinheit ist ausgebildet, eine Batteriespannung der Batterie zu messen. Der Temperatursensor ist ausgebildet, eine Temperatur der Batterie zu messen. Der Kontroller ist mit der Strommesseinheit, der Spannungsmesseinheit und dem Temperatursensor verbundenen und ausgebildet, das Verfahren nach dem ersten Erfindungsaspekt auszuführen.

Ein dritter Aspekt der Erfindung führt ein Kraftfahrzeug mit einem elektrischen Antriebsmotor zum Bewegen des Kraftfahrzeuges und einem mit dem elektrischen Antriebsmotor verbundenen Batteriesystem nach dem zweiten Erfindungsaspekt ein.

### Zeichnungen

### Kurzbeschreibung der Abbildungen

Die Erfindung wird im Folgenden anhand von Abbildungen von Ausführungsbeispielen näher erläutert. Es zeigen:
Fig. 1 ein Ausführungsbeispiel eines erfindungsgemäßen Batteriesystems; und
Fig. 2 ein Ausführungsbeispiel eines erfindungsgemäßen Verfahrens.

### Ausführliche Beschreibung der Abbildungen

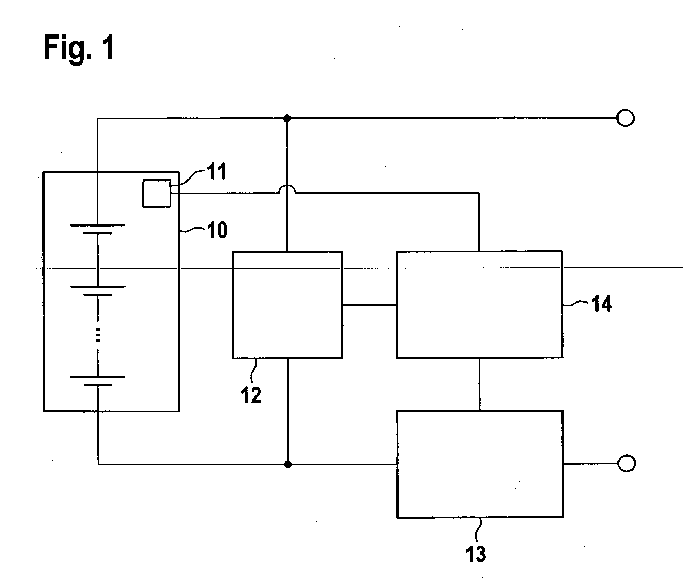

Fig. 1 zeigt ein Ausführungsbeispiel eines erfindungsgemäßen Batteriesystems. Eine Batterie 10 ist mit einem Temperatursensor 11 ausgestattet, welcher in möglichst großer räumlicher Nähe zu wenigstens einer Batteriezelle der Batterie 10 angeordnet ist. Mit den beiden Batteriepolen der Batterie 10 ist eine Spannungsmesseinheit 12 verbunden, welche die jeweils gegebene Batteriespannung misst. In einem der Strompfade der Batterie ist eine Strommesseinheit 13 angeordnet, welche den durch die Batterie 10 fließenden Batteriestrom misst. Die Strommesseinheit 13 kann beispielsweise als ohmscher Widerstand einer geringen, exakt bekannten Größe und einer zweiten Spannungsmesseinheit oder aber als Hall-Sensor aufgebaut sein. Temperatursensor 11, Spannungsmesseinheit 12 und Strommesseinheit 13 sind mit einem Kontroller 14 verbunden, welcher das Verhalten der Batterie 10 überwacht und charakterisiert, indem er das erfindungsgemäße Verfahren zur Bestimmung der von einer Batterie zur Verfügung stellbaren oder aufnehmbaren Leistung durchführt.

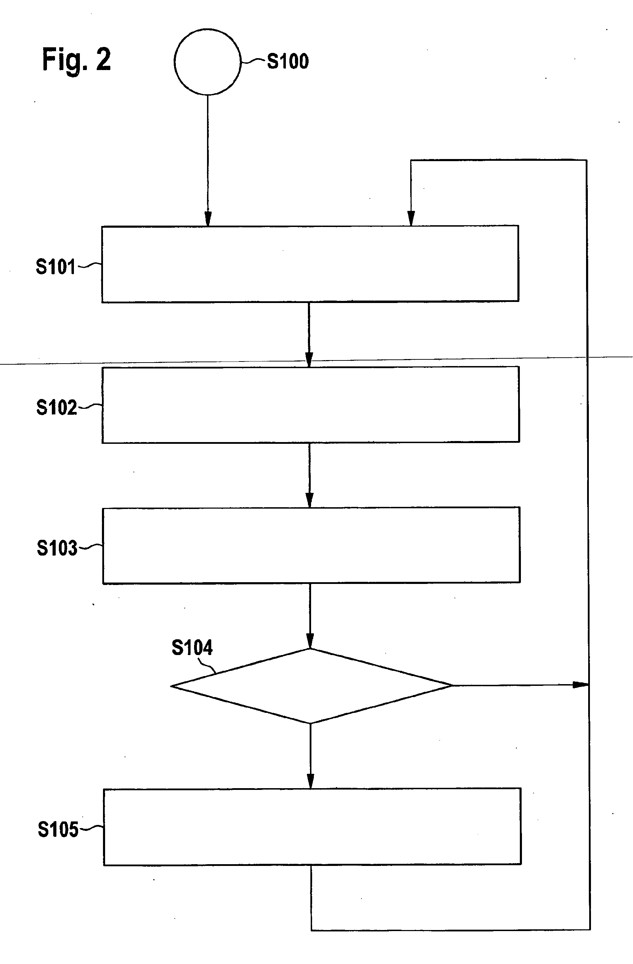

Fig. 2 zeigt ein Ausführungsbeispiel eines erfindungsgemäßen Verfahrens. Das Verfahren startet in Schritt S100. In Schritt S101 wird eine Zustandsgröße der Batterie, insbesondere eine Batterietemperatur und/oder ein Ladezustand bestimmt. Die Zustandsgröße der Batterie dient in Schritt S102 zum Bestimmen einer von der Batterie während eines vorbestimmten Belastungszeitraumes zur Verfügung stellbaren oder aufnehmbaren Leistung anhand einer Tabelle von Leistungswerte und der Zustandsgröße der Batterie als Zugriffsparameter für die Tabelle. Im folgenden Schritt 103 wird eine Belastung der Batterie anhand eines Betriebsparameters der Batterie, insbesondere eines Batteriestromes und/oder einer Batteriespannung, gemessen, während gleichzeitig ein Belastungszeitraum gemessen wird, in dem die Belastung der Batterie gegeben ist. Im nachfolgenden Schritt S104 wird der gemessene Belastungszeitraum mit einem Vergleichsbereich verglichen, der den vorbestimmten Belastungszeitraum enthält. Auf diese Weise wird festgestellt, ob ein dem in der Tabelle erfassten Belastungsfall ähnlicher tatsächlicher Belastungsfall aufgetreten ist. Wenn der Belastungszeitraum in dem Vergleichsbereich liegt, wird in Schritt S105 eine Korrekturroutine ausgeführt. Andernfalls ist kein aussagekräftiger Belastungsfall aufgetreten, weshalb zum Beginn des Verfahrens in Schritt S101 zurück verzweigt wird. Die Korrekturroutine von Schritt S105 umfasst wenigstens ein Vergleichen des Leistungswertes der Tabelle und der gemessenen Belastung, ein Bestimmen eines Korrekturwertes für den Leistungswert der Tabelle anhand eines Ergebnisses des Vergleichs des Leistungswertes der Tabelle und der gemessenen Belastung und eine Korrektur des Leistungswertes der Tabelle anhand des Korrekturwertes.

## Patentansprüche

1. Verfahren zur Bestimmung der von einer Batterie zur Verfügung stellbaren oder aufnehmbaren Leistung mit den Schritten:
-- Bestimmen einer Zustandsgröße der Batterie, wobei die Zustandsgröße eine Batterietemperatur und/oder ein Ladezustand (S101) ist;
-- Bestimmen einer von der Batterie während eines vorbestimmten Belastungszeitraumes zur Verfügung stellbaren oder aufnehmbaren Leistung anhand einer Tabelle von Leistungswerten und der Zustandsgröße der Batterie, wobei die Zustandsgröße der Batterie als Zugriffsparameter für die Tabelle dient (S102);
-- Messen einer Belastung der Batterie anhand eines Betriebsparameters der Batterie, wobei der Betriebsparameter ein Batteriestrom und/oder eine Batteriespannung (S103) ist;
**dadurch gekennzeichnet, dass** die Schritte:
-- Messen eines Belastungszeitraumes, in dem die Belastung der Batterie gegeben ist (S103);
-- Vergleichen des gemessenen Belastungszeitraumes mit einem Vergleichsbereich, der den vorbestimmten Belastungszeitraum enthält (S104); und
-- Ausführen einer Korrekturroutine, wenn der Belastungszeitraum in dem Vergleichsbereich liegt (S105),
durchgeführt werden,
wobei die Korrekturroutine wenigstens ein Vergleichen des Leistungswertes der Tabelle und der gemessenen Belastung, ein Bestimmen eines Korrekturwertes für den Leistungswert der Tabelle anhand eines Ergebnisses des Vergleichs des Leistungswertes der Tabelle und der gemessenen Belastung und eine Korrektur des Leistungswertes der Tabelle anhand des Korrekturwertes umfasst.

2. Das Verfahren von Anspruch 1, bei dem der Betriebsparameter der Batterie die Batteriespannung umfasst und der bestimmte Korrekturwert abhängig von einer Differenz der Batteriespannung am Ende des Belastungszeitraumes zu einer minimalen bzw. maximalen zulässigen Batteriespannung, insbesondere 2,8V bzw. 4,2V, ist.

3. Das Verfahren von einem der Ansprüche 1 oder 2, bei dem der Betriebsparameter der Batterie den Batteriestrom umfasst und der bestimmte Korrekturwert abhängig von einer Differenz des Batteriestromes über den Belastungszeitraum zu einem maximal zulässigen Batteriestrom in Auflade- bzw. Entladerichtung ist.

4. Das Verfahren von einem der vorhergehenden Ansprüche, bei dem der bestimmte Korrekturwert abhängig von einer Differenz des Leistungswertes der Tabelle und der gemessenen Belastung der Batterie ist.

5. Das Verfahren von einem der vorhergehenden Ansprüche, bei dem die Korrekturroutine einen zusätzlichen Schritt des Korrigierens von weiteren Leistungswerten der Tabelle, welche zu dem Leistungswert der Tabelle in der Tabelle benachbart sind, anhand des Korrekturwertes umfasst.

6. Das Verfahren von Anspruch 5, bei dem der Korrekturwert für jeden weiteren Leistungswert gewichtet wird, wobei ein Abstand des jeweiligen weiteren Leistungswertes zu dem Leistungswert der Tabelle berücksichtigt wird.

7. Ein Batteriesystem mit einer Batterie (10) und einer mit der Batterie (10) verbundenen Batteriemanagementeinheit, welche über wenigstens eine Strommesseinheit (13), welche ausgebildet ist, einen Batteriestrom der Batterie zu messen, eine Spannungsmesseinheit (12), welche ausgebildet ist, eine Batteriespannung der Batterie zu messen, einen Temperatursensor (11), welcher ausgebildet ist, eine Temperatur der Batterie zu messen, und einen mit der Strommesseinheit (13), der Spannungsmesseinheit (12) und dem Temperatursensor (11) verbundenen Kontroller (14) verfügt,
**dadurch gekennzeichnet,**
**dass** der Kontroller (14) ausgebildet ist, das Verfahren nach einem der vorhergehenden Ansprüche auszuführen.

8. Ein Kraftfahrzeug mit einem elektrischen Antriebsmotor zum Bewegen des Kraftfahrzeuges und einem mit dem elektrischen Antriebsmotor verbundenen Batteriesystem nach Anspruch 7.

## Claims

1. Method for determining the power that can be provided or absorbed by a battery, having the following steps:
-- determination of a state variable of the battery, the state variable being a battery temperature and/or a state of charge (S101);
-- determination of a power that can be provided or absorbed by the battery during a predetermined load time period on the basis of a table of power values and the state variable of the battery, the state variable of the battery acting as access parameter for the table (S102);
-- measurement of a load on the battery on the basis of an operational parameter of the battery, the operational parameter being a battery current and/or a battery voltage (S103);
**characterized in that** the following steps are implemented:
-- measurement of a load time period, in which the load on the battery is provided (S103);
-- comparison of the measured load time period with a comparison region which contains the predetermined load time period (S104); and
-- implementation of a correction routine when the load time period is in the comparison region (S105), wherein the correction routine comprises at least comparison of the power value from the table and the measured load, determination of a correction value for the power value from the table on the basis of a result of the comparison of the power value from the table and the measured load, and correction of the power value from the table on the basis of the correction value.

2. Method from Claim 1, in which the operational parameter of the battery comprises the battery voltage, and the determined correction value is dependent on a difference between the battery voltage at the end of the load time period and a minimum or maximum permissible battery voltage, in particular 2.8 V or 4.2 V, respectively.

3. Method from either of Claims 1 and 2, in which the operational parameter of the battery comprises the battery current, and the determined correction value is dependent on a difference between the battery current over the load time period and a maximum permissible battery current in the charging or discharging direction.

4. Method from one of the preceding claims, in which the determined correction value is dependent on a difference between the power value from the table and the measured load on the battery.

5. Method from one of the preceding claims, in which the correction routine comprises an additional step of correcting further power values from the table which, in the table, are adjacent to the power value from the table, on the basis of the correction value.

6. Method from Claim 5, in which the correction value is weighted for each further power value, wherein a gap between the respective further power value and the power value from the table is taken into consideration.

7. Battery system with a battery (10) and a battery management unit, which is connected to the battery (10) and has at least one current measurement unit (13) which is designed to measure a battery current of the battery, a voltage measurement unit (12) which is designed to measure a battery voltage of the battery, a temperature sensor (11) which is designed to measure a temperature of the battery, and a controller (14) which is connected to the current measurement unit (13), the voltage measurement unit (12) and the temperature sensor (11),
**characterized**
**in that** the controller (14) is designed to implement the method according to one of the preceding claims.

8. Motor vehicle with an electric drive motor for moving the motor vehicle and a battery system according to Claim 7, connected to the electric drive motor.

## Revendications

1. Procédé pour déterminer une puissance pouvant être mise à disposition ou pouvant être absorbée par une batterie, comprenant les étapes suivantes :
- détermination d'une grandeur d'état de la batterie, la grandeur d'état étant une température de batterie et/ou un état de charge (S101) ;
- détermination d'une puissance pouvant être mise à disposition ou absorbée par la batterie pendant une période de sollicitation prédéfinie à l'aide d'un tableau de valeurs de puissance et de la grandeur d'état de la batterie, la grandeur d'état de la batterie servant de paramètre d'accès pour le tableau (S102) ;
- mesure d'une sollicitation de la batterie à l'aide d'un paramètre de fonctionnement de la batterie, le paramètre de fonctionnement étant un courant de batterie et/ou une tension de batterie (S103) ; **caractérisé en ce que** les étapes :
- mesure d'une période de sollicitation au cours de laquelle la sollicitation de la batterie est définie (S103) ;
- comparaison de la période de sollicitation mesurée avec une plage de comparaison qui contient la période de sollicitation prédéfinie (S104) ; et
- réalisation d'une routine de correction lorsque la période de sollicitation se trouve dans la plage de comparaison (S105),
sont exécutées,
la routine de correction comprenant au moins une comparaison de la valeur de puissance du tableau et de la sollicitation mesurée, une détermination d'une valeur de correction pour la valeur de puissance du tableau à l'aide d'un résultat de la comparaison de la valeur de puissance du tableau et de la sollicitation mesurée et une correction de la valeur de puissance du tableau à l'aide de la valeur de correction.

2. Procédé selon la revendication 1, selon lequel le paramètre de fonctionnement de la batterie comprend la tension de la batterie et la valeur de correction déterminée est dépendante d'une différence entre la tension de la batterie à la fin de la période de sollicitation et une tension de batterie minimale ou maximal admissible, notamment 2,8 V ou 4,2 V.

3. Procédé selon l'une des revendications 1 ou 2, selon lequel le paramètre de fonctionnement de la batterie comprend le courant de la batterie et la valeur de correction déterminée est dépendante d'une différence entre le courant de la batterie pendant la période de sollicitation et un courant de batterie maximal admissible dans la direction de charge ou de décharge.

4. Procédé selon l'une des revendications précédentes, selon lequel la valeur de correction déterminée est dépendante d'une différence entre la valeur de la puissance du tableau et de la sollicitation mesurée de la batterie.

5. Procédé selon l'une des revendications précédentes, selon lequel la routine de correction inclut une étape supplémentaire de correction à l'aide de la valeur de correction de valeurs de puissance supplémentaires du tableau, lesquelles sont voisines de la valeur de la puissance du tableau dans le tableau.

6. Procédé selon la revendication 5, selon lequel la valeur de correction est pondérée pour chaque valeur de puissance supplémentaire, un écart entre la valeur de puissance supplémentaire et la valeur de puissance du tableau étant pris en compte.

7. Système de batterie comprenant une batterie (10) et une unité de gestion de batterie reliée avec la batterie (10), laquelle dispose d'au moins une unité de mesure du courant (13), laquelle est configurée pour mesurer un courant de batterie de la batterie, d'une unité de mesure de tension (12), laquelle est configurée pour mesurer une tension de batterie de la batterie, d'une sonde de température (11), laquelle est configurée pour mesurer une température de la batterie, et d'un contrôleur (14) relié avec l'unité de mesure du courant (13), l'unité de mesure de tension (12) et la sonde de température (11),
**caractérisé en ce que**
le contrôleur (14) est configuré pour mettre en oeuvre le procédé selon l'une des revendications précédentes.

8. Véhicule automobile équipé d'un moteur de propulsion électrique pour déplacer le véhicule automobile et d'un système de batterie selon la revendication 7 relié avec le moteur de propulsion électrique.
